**Europäisches Patentamt**

**European Patent Office**

**Office européen des brevets**

(19)

(11) Veröffentlichungsnummer: **0 032 358**
**B1**

(12) EUROPÄISCHE PATENTSCHRIFT

(45) Veröffentlichungstag der Patentschrift:
03.10.84

(21) Anmeldenummer: 80810398.0

(22) Anmeldetag: 17.12.80

(51) Int. Cl.³: **H 03 L 1/02**, G 04 G 3/02,
G 04 F 5/06

(54) Oszillator mit digitaler Temperaturkompensation.

(30) Priorität: 10.01.80 CH 157/80

(43) Veröffentlichungstag der Anmeldung:
22.07.81 Patentblatt 81/29

(45) Bekanntmachung des Hinweises auf die Patenterteilung:
03.10.84 Patentblatt 84/40

(84) Benannte Vertragsstaaten:
DE FR GB

(56) Entgegenhaltungen:
FR - A - 2 249 377
US - A - 4 148 184
US - A - 4 159 622

PATENTS ABSTRACTS OF JAPAN, Band 3, Nr. 58, 18.
Mai 1979 Seite 4E111
IEE, Band 16, Nr. 154, Oktober 1979 TOKYO (JP) Y.
AKAHANE: "New Twin Quartz System Revolutionizes
Time-keeping Accuracy", Seiten 24-27
JAHRBUCH DER DEUTSCHEN GESELLSCHAFT FÜR
CHRONOMETRIE, Band 28, 1977 STUTTGART (DE) H.
EFFENBERGER: "Digitale Temperaturkompensation
von Schwingquarzoszillatoren mit Automatischem
Frequenzabgleich", Seiten 9-15

(73) Patentinhaber: SOCIETE SUISSE POUR L'INDUSTRIE
HORLOGERE MANAGEMENT SERVICES S.A., Rue
Stämpfli 96, CH-2500 Bienne (CH)

(72) Erfinder: Zumsteg, Alphonse, St. Niklausstrasse 24,
CH-4500 Solothurn (CH)

(74) Vertreter: Seehof, Michel et al, c/o AMMANN
PATENTANWAELTE AG BERN Schwarztorstrasse 31,
CH-3001 Bern (CH)

## Beschreibung

Die vorliegende Erfindung bezieht sich auf einen Quarzoszillator mit einer ersten Quarzoszillatorschaltung und einer zweiten Quarzoszillatorschaltung, wobei die Quarzresonatoren jeweils eine parabolische, aber untereinander verschiedene Temperaturabhängigkeit besitzen, bei dem in einer Temperaturkompensationsschaltung die Frequenzen beider Oszillatorschaltungen jeweils über Frequenzteiler geteilt, einem Detektor zugeführt und derart verknüpft werden, dass innerhalb eines vorgegebenen Temperaturbereiches eine von der Temperatur unabhängige Ausgangsfrequenz entsteht, wozu der Detektorausgang über einen Speicher, in welchem von der Temperatur abhängige Korrekturwerte gespeichert sind, an eine vor dem Frequenzteiler einer der beiden Frequenzteilerzweige eingefügte Additionsschaltung gelangt, die durch zeitweiliges Unterdrücken oder Addieren von Impulsen die Ausgangsfrequenz des Quarzoszillators korrigiert.

Ein solcher Oszillator wird in der US-A-4 159 622 vorgeschlagen und beschrieben. Dabei ist der Detektor als Phasendetektor ausgebildet, in welchem die vorbestimmten, unterschiedlichen Phasen der beiden Resonatoren miteinander verglichen und das Differenzsignal dem Speicher eingegeben werden.

Die Verwendung eines Phasendetektors weist im realen Anwendungsfall einige Nachteile auf, die in der Streuung der Parameter der Quarze sowie der verwendeten integrierten Schaltungen begründet ist und ein paarweises Auslesen der Quarze verlangt, während der Phasendetektor relativ aufwendig ist.

Es ist demgegenüber das Ziel der vorliegenden Erfindung, eine Temperaturkompensation anzugeben, die ohne grossen Aufwand und ohne paarweise Zusammenstellung der Quarzresonatoren eine grosse Genauigkeit erzielt.

Dieses Ziel wird durch einen in den Ansprüchen beschriebenen Oszillator erreicht.

Die Erfindung wird nun im einzelnen anhand eines Ausführungsbeispiels und einer Zeichnung näher erläutert werden.

Fig. 1 zeigt schematisch ein Zeitdiagramm je einer n-fachen Periode von beiden Quarzresonatoren,

Fig. 2 zeigt das parabolische Temperaturverhalten von zwei Niederfrequenzresonatoren in einer bestimmten Einstellung, und

Fig. 3 zeigt eine Blockschaltung eines erfindungsgemässen Oszillators.

Mit zwei Quarzresonatoren, wie sie in der erwähnten Literaturstelle angegeben sind, mit einer gleichen Sollfrequenz und verschobenen Temperaturinversionspunkten sowie mit gleichen parabolischen Temperaturkoeffizienten wäre eine ideale Temperaturkompensation möglich, denn es gilt:

$$f_1(T) = f_{10}(1 + \beta_1(T - T_1)^2)$$
und
$$f_2(T) = f_{20}(1 + \beta_2(T - T_2)^2), \text{ wobei}$$

$T_1$, $T_2$ die Inversionstemperaturen, $f_{10}$, $f_{20}$ die Sollfrequenzen bei den Inversionstemperaturen und $\beta_1$, $\beta_2 = -3,6 \cdot 10^{-8}/(°C)^2$ die quadratischen oder parabolischen Temperaturkoeffizienten sind und angenommen wird, dass die beiden parabolischen Koeffizienten gleich $\beta$ sind.

Daraus ergibt sich als Differenz

$$f_1 - f_2 \cong 2\beta T(T_1 - T_2)f_N + C,$$

wobei $f_N \cong f_{10} \cong f_{20}$ und das Glied $T^2$ vernachlässigt werden. Die Differenz ist also eine lineare Funktion der Temperatur. Es ist möglich, diese Differenz elektronisch zu quadrieren, mit einer geeigneten Konstanten zu multiplizieren und das Resultat zur Frequenz des ersten Resonators zu addieren.

Man kann dann leicht ersehen, dass

$$f(T) = f_1(T) + k(f_2(T) - f_1(T))^2$$

eine ideale Temperaturkompensation darstellt, falls

$$k = \frac{-1}{4\beta(T_1 - T_2)^2 f_N} \text{ und } f_{20} = \frac{f_{10}}{1 + \beta(T_1 - T_2)^2}$$

Der oben erwähnte Fall ist einfach zu realisieren, doch ist der damit erzielte Gewinn an Genauigkeit gering, was unter anderem auf die unvermeidliche Streuung der Quarzparameter zurückzuführen ist. Es ist daher notwendig, die Quarze paarweise auszulesen, um jeweils die gleichen Werte für die parabolischen Koeffizienten zu finden. Dieses paarweise Auslesen ist notwendig, denn bei einer Abweichung von $\beta$ um 10%, die in der Praxis vorkommt, beträgt der Gewinn an Genauigkeit gegenüber einem Oszillator ohne Temperaturkompensation höchstens einen Faktor 2.

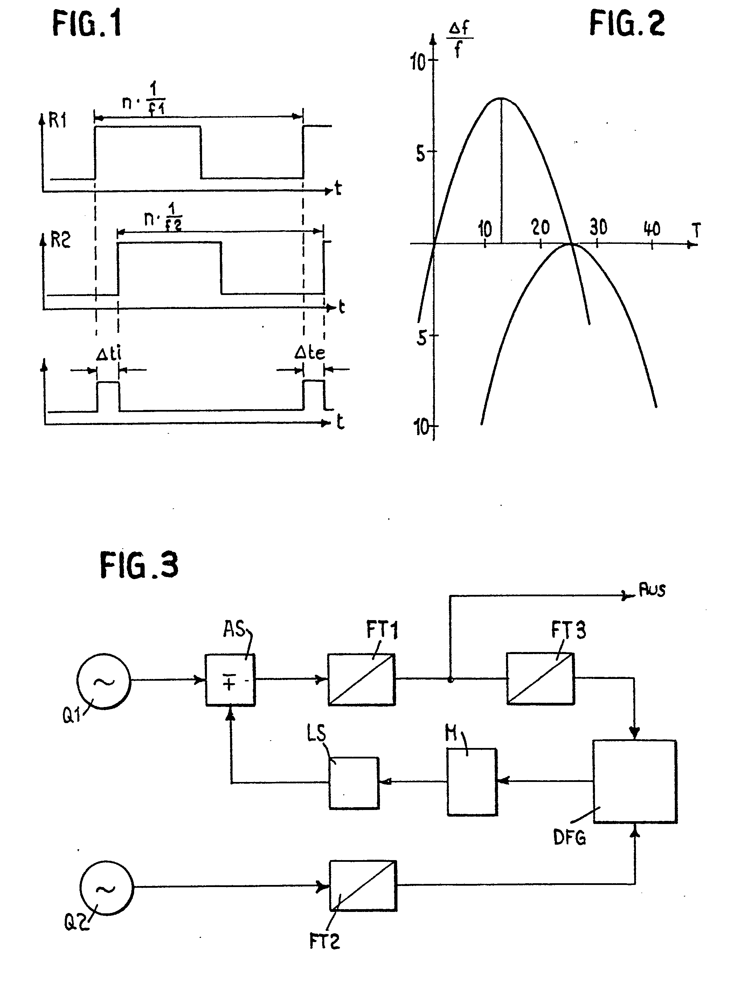

Eine weitere Fehlerquelle ist die Streuung der Werte für die integrierten Schaltungen und für die Abstimmkondensatoren, welche auf die parabolischen Koeffizienten wirken, sowie die Streuung der Inversionspunkte. Eine Streuung von 2°C stellt die typische statistische Streuung (S) dar, das heisst, dass 68% der Inversionspunkte sich innerhalb des Intervalls $T_1 \pm 2°C$ befinden. Bei niedrigen Frequenzen ergeben sich weitere Nachteile dadurch, dass für die Messung der Differenzfrequenz $f_1 - f_2$ eine Zeitbasis nötig ist, wobei die Frequenz eines der beiden Quarzresonatoren verwendet werden kann. Die Differenzfrequenz wird dadurch ermittelt, dass die Differenz der Schwingungsdauer der n-fachen Perioden der beiden Resonatoren gemessen wird, wobei diese Differenz gemäss Figur 2 $\Delta t_i - \Delta t_e$ beträgt. Bei jeder Messung kann ein Fehler von $\Delta t = \dfrac{1}{f}$ entstehen, falls Resonator 1 als Zeitbasis verwendet wurde. Berechnungen zeigen, dass, um eine relative Genauigkeit von $2 \cdot 10^{-7}$ zu erreichen, eine Multiperiode von 305 s notwendig ist, falls $f_1$ 32 kHz beträgt. Somit kann eine Korrektur erst nach dieser Zeit erfolgen.

Wie in der Einleitung erwähnt wurde, ist es das Ziel der vorliegenden Erfindung, die oben geschilderten Nachteile zu umgehen und einen Oszillator anzugeben, bei welchem das paarweise Auslesen der Quarze vor deren Montage nicht notwendig ist, wodurch es möglich ist, Quarze mit jeweils unterschiedlichen parabolischen Koeffizienten zu verwenden.

Um die Aufgabe zu lösen, ist es notwendig, die Frequenzen beider Resonatoren bei drei verschiedenen Temperaturen zu messen, um die drei Parameter zu ermitteln, die das Temperaturverhalten der Resonatoren bestimmen, was sich als Parabel darstellen lässt. Die nachfolgenden Ausführungen gelten für Quarze in Stimmgabelform.

Es seien $T_I$, $T_S$ und $T_R$ die drei Temperaturen und $f_{1I}$, $f_{1S}$ und $f_{1R}$ die drei entsprechenden Frequenzen von Resonator 1, wobei sinngemäss für Resonator 2 verfahren wird. Darauf lassen sich $f_{1o}$, $T_1$ und $\beta_1$ für Resonator 1 und entsprechend für Resonator 2 berechnen.

Die Korrektur kann nun in allgemeiner Form geschrieben werden:

$$f(T) = f_1(T) + k(f_2(T) - f_1(T) - \Delta f)P$$

wobei P eine Funktion von $\beta_1$ und $\beta_2$
und k eine Funktion von $T_1$, $T_2$, $\beta_1$, $\beta_2$ sind.

Versuche ergaben für $\dfrac{\beta_1 - \beta_2}{\beta_1 + \beta_2} \leqslant 0{,}1$

$$k = \frac{-1}{2(\beta_1 + \beta_2)(T_2 - T_1)^2 f_N} \cdot (1 - \frac{\beta_1 - \beta_2}{\beta_1 + \beta_2})^2$$
$$P = 2(1 + \frac{\beta_1 - \beta_2}{\beta_1 + \beta_2})$$

die sich ausrechnen lassen.

Dabei ist $\Delta f$ optimal für $\Delta f = f_2(T_1) - f_N$, wobei $f_N$ die gewünschte nominale Frequenz ist.

Die Korrekturfunktionen können in einen PROM-Speicher eingegeben werden.

Man kann leicht ausrechnen, dass es mit dieser allgemeinen Korrekturfunktion beispielsweise möglich ist, in einem Temperaturintervall von $-5\,°C$ bis $45\,°C$ eine Abweichung zu erzielen, die unter $2{,}10^{-7}$ bleibt, falls

$\beta_1 = -3{,}6 \cdot 10^{-8}/(°C)^2$
$T_1 = 35\,°C$ und $T_2 = +5\,°C$
$\beta_2 = -4{,}4 \cdot 10^{-8}/(°C)^2$

betragen.

Falls einer der Parameter eines Quarzes mit genügender Genauigkeit bekannt ist und die integrierten Schaltungen und die Abstimmkondensatoren nicht stark streuen, ist es auch möglich, die Messungen bei nur zwei verschiedenen Temperaturen durchzuführen.

Dieses System kann auch bei zwei Resonatoren mit sehr verschiedenen Frequenzen verwendet werden, wobei nach geeigneten Frequenzteilungen wie nach obigem Beispiel vorgegangen werden kann.

Die Differenzfrequenz $f_1 - f_2$ kann mittels eines Hochfrequenzoszillators als Zeitbasis viel rascher gemessen werden. Zum Beispiel kann ein 5-MHz-Oszillator mit symmetrischem rechteckigem Signal als Zeitbasis verwendet werden. Damit kann die Messung von $f_1 - f_2$ mit einer relativen Genauigkeit von $2.10^{-7}$ in einer Sekunde durchgeführt werden.

Die Stabilitätsanforderungen an diesen Hochfrequenzoszillator sind gering, denn um auf $2.10^{-7}$ die Frequenz eines Niederfrequenzresonators, der einen parabolischen Koeffizienten von $\beta = -4.10^{-8}$ aufweist, in einem Temperaturbereich von $\pm 30\,°C$ um den Temperaturinversionspunkt zu korrigieren, genügt eine Genauigkeit von 0,5%, denn $\beta(\Delta T)^2 = 4.10^{-8} \cdot 900 = -36.10^{-6}$ und $\dfrac{2.10^{-7}}{36.10^{-6}} = 0{,}5\%$.

Das bedeutet, dass ein integrierter Oszillator des RC-Typs verwendet werden kann.

Ein Faktor E in dessen Frequenz bedeutet auch einen Faktor E für den Wert $f_1 - f_2$. Dadurch ist es möglich, durch Anpassung des Hochfrequenzoszillators den Wert von k anzugleichen.

In Fig. 3 ist ein Blockschema eines Ausführungsbeispiels dargestellt. Vom ersten Quarzresonator Q1 gelangen die Impulse zu einer Additionsschaltung AS und anschliessend zu einem Frequenzteiler FT1, wo die Frequenz auf 1 Hz herabgesetzt wird, und zum Ausgang AUS, von wo sie auf einen Schrittschaltmotor gegeben werden. Diese Impulse gelangen auch zu einem weiteren Frequenzteiler FT3, der je nach den Anforderungen an die Temperaturkorrektur auch weggelassen werden kann, und schliesslich zu einem Differenzfrequenzgenerator DFG, an welchen die Impulse des zweiten Quarzresonators Q2, nach geeigneter Unterteilung im Frequenzteiler FT2, gelangen, so dass bei der Temperatur $T_1$ beide Frequenzen gleich sind. Der Differenzfrequenzgenerator zur Messung von $f_1 - f_2$ wird von einem unabhängigen Hochfrequenzoszillator, in vorliegendem Fall ein integriertes RC-Glied, gesteuert. Die Differenzfrequenz gelangt zu einer Korrekturschaltung M, die ein PROM aufweist, in welchem die Korrekturfunktionen (k, P) gespeichert sind, und anschliessend zu einer logischen Schaltung LS, welche die Additionsschaltung AS steuert, um selektiv von Zeit zu Zeit einen Impuls zu sperren oder zu addieren und so die Korrektur durchzuführen. Nach Teilung auf 1 Hz gelangen die Impulse zum Ausgang.

Durch Verändern der Frequenz des RC-Oszillators ist es möglich, auf die im PROM gespeicherte Funktion von k einzuwirken und somit die Korrektur mit einem hohen Auflösungsvermögen durchzuführen.

Der Hochfrequenzoszillator muss nicht ständig in Betrieb sein, sondern kann vielmehr zeitweilig ein- und ausgeschaltet werden. Dabei richten sich die Schaltzeiten nach der Häufigkeit der Temperaturschwankungen.

Der vorliegend beschriebene Oszillator kann mit Vorteil überall dort, wo eine hohe Genauigkeit und ein günstiges Temperaturverhalten erwünscht ist und wo das dafür verfügbare Volumen klein ist, verwendet werden. Dies trifft beispielsweise bei einer Armbanduhr oder bei einer Filmkamera zu.

### Patentansprüche

1. Quarzoszillator mit einer ersten Quarzoszillatorschaltung (Q1) und einer zweiten Quarzoszillatorschaltung (Q2), wobei die Quarzresonatoren jeweils eine parabolische, aber untereinander verschiedene Temperaturabhängigkeit besitzen, bei dem in einer Temperaturkompensationsschaltung die Frequenzen beider Oszillatorschaltungen jeweils über Frequenzteiler (FT1, FT2; FT3) geteilt, einem Detektor (DF6) zugeführt und derart verknüpft werden, dass innerhalb eines vorgegebenen Temperaturbereiches eine von der Temperatur unabhängige Ausgangsfrequenz entsteht, wozu der Detektorausgang über einen Speicher (M), in welchem von der Temperatur abhängige Korrekturwerte gespeichert sind, an eine vor dem Frequenzteiler (FT1) einer der beiden Frequenzteilerzweige eingefügte Additionsschaltung (AS) gelangt, die durch zeitweiliges Unterdrücken oder Addieren von Impulsen die Ausgangsfrequenz des Quarzoszillators korrigiert, dadurch gekennzeichnet, dass der Detektor ein Differenzfrequenzgenerator (DFG) ist, in welchem die Differenz $(\Delta t_i - \Delta t_e)$ der Schwingungsdauer der n-fachen Perioden der beiden Quarzoszillatorschaltungen (Q1, Q2), die einen unterschiedlichen Temperaturinversionspunkt (T1, T2) aufweisen, gemessen wird und der Speicher (M), in welchem die Korrekturwerte (k, P) gespeichert sind, als PROM ausgebildet ist, und dass die Temperaturkompensationsschaltung ferner einen unabhängigen Hochfrequenzoszillator aufweist, der zur Messung der Differenzfrequenz im Differenzfrequenzgenerator (DFG) dient und durch welchen die Korrekturwerte im PROM geändert werden, wenn eine Änderung seiner Frequenz eintritt.

2. Quarzoszillator nach Anspruch 1, dadurch gekennzeichnet, dass die Quarzoszillatorschaltungen (Q1, Q2) eine Frequenz von 32 kHz aufweisen und der Hochfrequenzoszillator eine integrierte RC-Schaltung ist.

3. Quarzoszillator nach Anspruch 1 oder 2, dadurch gekennzeichnet, dass der Hochfrequenzoszillator derart geschaltet ist, dass er nur zeitweilig in Betrieb ist.

4. Verfahren zur Herstellung eines Quarzoszillators nach Anspruch 1, dadurch gekennzeichnet, dass Quarzresonatoren des Stimmgabeltyps mit verschiedenen parabolischen Koeffizienten und Temperaturinversionspunkten ohne vorgängiges paarweises Auslesen verwendet werden und die Frequenzen beider Quarze bei drei verschiedenen Temperaturen gemessen werden.

### Claims

1. Quartz crystal oscillator with a first quartz crystal oscillator circuit (Q1) and a second quartz crystal oscillator circuit (Q2) the quartz crystal resonators of which having a parabolic temperature characteristic, these temperature characteristics differing from one another, in which the frequencies of the two oscillator circuits, each after having been divided into frequency dividers (FT1, FT2; FT3) are delivered to a detector (DFG) of a temperature compensation circuit and combined in order to produce, within a predetermined range of temperature, an output frequency independent of the temperature, the output of the detector being connected by a memory (M) in which correction values depending on the temperature are memorized to an adding circuit (AS) inserted before one of the frequency dividers (FT1) of the two frequency divider branches, said adding circuit correcting the output frequency of the quartz crystal oscillator by temporarily adding or suppressing pulses, characterized in that the detector is a difference frequency generator (DFG) in which the difference $(\Delta ti - \Delta te)$ of the duration of n periods of both quartz crystal oscillator circuits (Q1, Q2) having a different temperature inversion point (T1, T2) is measured, the memory (M) in which the correction values (k, P) are memorized being a PROM memory and in that the temperature compensation circuit further comprises an independent high-frequency oscillator for measuring the frequency difference in the difference frequency generator (DFG) and for changing the correction values in the PROM memory by a variation of its frequency.

2. Quartz crystal oscillator according to claim 1, characterized in that the quartz crystal oscillator circuits (Q1, Q2) have a frequency of 32 kHz and in that the high-frequency oscillator is an integrated RC-oscillator.

3. Quartz crystal oscillator according to claim 1 or 2, characterized in that the high-frequency oscillator is so connected that it is actuated only temporarily.

4. Process of manufacturing of a quartz crystal oscillator according to claim 1, characterized in that quartz crystal resonators of the tuning fork type with different parabolic coefficients and inversion temperature points are used without having been paired previously and in that the frequencies of both quartz crystal resonators are measured at three different temperatures.

### Revendications

1. Oscillateur à quartz avec un premier circuit oscillateur à quartz (Q1) et un second circuit oscillateur à quartz (Q2) dont les résonateurs à quartz ont une caractéristique de température parabolique, ces caractéristiques différant entre elles, dans lequel les fréquences des deux circuits oscillateurs, chacune après division de fréquence dans des diviseurs de fréquence (FT1, FT2; FT3), sont délivrées à un détecteur (DFG) d'un circuit de compensation de température et combinées de manière à produire, dans un domaine de température prédéterminé, une fréquence de sortie indépendante de la température, la sortie du détecteur étant reliée par une mémoire (M) dans laquelle des valeurs de correction fonction de la température sont mémorisées, à un circuit d'addition (AS) inséré avant l'un des diviseurs de fréquence (FT1) des deux branches de division de fréquence, qui corrige la fréquence de sortie de l'oscillateur à quartz par addition ou suppression provisoire d'impulsions, caractérisé en ce que le détecteur est un générateur de différence de fréquence (DFG) dans lequel la différence ($\Delta ti - \Delta te$) des durées de n périodes des deux circuit oscillateurs à quartz (Q1, Q2) avec un point d'inversion de température (T1, T2) différent est mesurée, la mémoire (M) dans laquelle les valeurs de correction (k, P) sont mémorisées étant une mémoire PROM, et en ce que le circuit de compensation en température comprend en outre un oscillateur de haute fréquence indépendant servant à la mesure de la différence de fréquence dans le générateur de différence de fréquence (DFG) et permettant de modifier les valeurs de correction dans la mémoire PROM par une variation de sa fréquence.

2. Oscillateur à quartz selon la revendication 1, caractérisé en ce que les circuits oscillateurs à quartz (Q1, Q2) ont une fréquence de 32 kHz et en ce que l'oscillateur de haute fréquence est un oscillateur RC intégré.

3. Oscillateur à quartz selon la revendication 1 ou 2, caractérisé en ce que l'oscillateur de haute fréquence est branché de manière à n'être en service que temporairement.

4. Procédé de fabrication d'un oscillateur à quartz selon la revendication 1, caractérisé en ce que des résonateurs à quartz du type à diapason avec des coéfficients paraboliques et des points d'inversion de température différents sont utilisés sans appariement préalable et en ce que les fréquences des deux quartz sont mesurées à trois températures différentes.

# 0 032 358

# FIG.1

# FIG.2

# FIG.3

7